# EUROPEAN PATENT APPLICATION

(11) **EP 4 300 818 A1**
(43) Date of publication of application: **03.01.2024**
(21) Application number: 23182112.5
(22) Date of filing: 28.06.2023
(51) Int. Cl.: H03D 7/16, H04B 1/00

(54) **FREQUENCY AGILE BAND SELECT FILTER**

(30) Priority: 30.06.2022 US 202263357265 P
(71) Applicant: Nanowave Technologies Inc., Etobicoke, Ontario M8W 4W3 (CA)
(72) Inventor: Nicholls, Charles, Nepean, K2G 4Y7 (CA); Hamdane, Walid, 9 Menzah (TN)
(74) Representative: Bryn Aarflot AS

(57) **Abstract**

A filter, apparatus, system and method are provided for implementing a band select filter, for example a frequency agile band select filter. In an implementation, the filter includes two separate signal generators configured to provide different local oscillator signals to an input mixer and to an output mixer, resulting in the filter output frequency being different from the filter input frequency. This is in contrast to known approaches which use the same signal generator to drive both input and output mixers. The filter may include two bandpass filters, three mixers, and three signal generators, each signal generator uniquely associated with one of the mixers, and configured to provide bandwidth control. A system of filters may include a set of bandpass filters, a plurality of sets of mixers, and a plurality of sets of signal generators, each set of signal generators being associated with a different set of mixers.

## Description

### FIELD

The present disclosure relates generally to radio frequency systems, and more particularly to filters and frequency conversion (up-conversion and/or down-conversion).

### BACKGROUND

Radio systems generally operate over specific frequency bands and thus generally require means to limit the operational bandwidth of the system in both the transmission and reception modes. Two broad categories of radio frequency systems include Radio Detection And Ranging (RADAR) and telecommunications systems.

It remains desirable however to develop further improvements and advancements in relation to radio frequency systems, including in relation to RADAR and telecommunications systems, to overcome shortcomings of known techniques, and to provide additional advantages thereto.

This section is intended to introduce various aspects of the art, which may be associated with the present disclosure. This discussion is believed to assist in providing a framework to facilitate a better understanding of particular aspects of the present disclosure. Accordingly, it should be understood that this section should be read in this light, and not necessarily as admissions of prior art.

### BRIEF DESCRIPTION OF THE DRAWINGS

Embodiments of the present disclosure will now be described, by way of example only, with reference to the attached Figures.
FIG. 1 is a block diagram of a known filter transposition architecture including two mixers and one bandpass filter.
FIG. 2 is a block diagram of a known filter transposition architecture including eight mixers and sixteen bandpass filters.
FIG. 3 is a block diagram of a filter transposition architecture according to an embodiment of the present disclosure, including two mixers and one bandpass filter, and two different frequency sources.
FIG. 4 is a block diagram of a multi-channel frequency agile band select filter according to an embodiment of the present disclosure.
FIG. 5 is a block diagram of a single channel of the frequency agile band select filter of FIG. 4 according to an embodiment of the present disclosure.
FIG. 6 is a plot illustrating outputs of the single channel shown in FIG. 5 of the frequency agile band select filter according to an embodiment of the present disclosure.
FIG. 7 is a block diagram of a multi-channel frequency agile band select filter with common input preselect filter according to an embodiment of the present disclosure.
FIG. 8 is a block diagram of a frequency agile band select filter with channel select filter bandwidth control according to an embodiment of the present disclosure.
FIG. 9 is a plot illustrating overlapping filter characteristics of the frequency agile band select filter with channel select filter bandwidth control according to the embodiment of FIG. 8.
FIG. 10 is a block diagram of a multi-channel frequency agile band select filter with IF filter bandwidth control according to an embodiment of the present disclosure.
FIG. 11 is a block diagram of a single channel of the frequency agile band select filter of FIG. 8 or FIG. 10 according to an embodiment of the present disclosure.
FIG. 12 is a plot illustrating outputs of the single channel shown in FIG. 11 of the frequency agile band select filter including filter bandwidth control according to an embodiment of the present disclosure.
FIG. 13 is a block diagram of an example computerized device or system 1300 that may be used in implementing one or more aspects or components of an embodiment of a frequency agile band select filter in accordance with the present disclosure.

Throughout the drawings, sometimes only one or fewer than all of the instances of an element visible in the view are designated by a lead line and reference character, for the sake only of simplicity and to avoid clutter. It will be understood, however, that in such cases, in accordance with the corresponding description, that all other instances are likewise designated and encompassed by the corresponding description.

### DETAILED DESCRIPTION

The following are examples of systems and methods relating to a frequency agile band select filter in accordance with embodiments of the present disclosure.

In an embodiment, the present disclosure provides a band select filter comprising: a first signal generator for generating a first transposition signal; an input mixer in communication with the first signal generator and configured to receive the first transposition signal and a radio frequency (RF) input at a first frequency within an first RF band, the input mixer configured to output a frequency-converted RF input based on mixing the RF input with the first transposition signal; a bandpass filter in communication with the input mixer and configured to receive the frequency-converted RF input, the bandpass filter producing a filter output based on applying a filter characteristic to the frequency-converted RF input; a second signal generator for generating a second transposition signal, the second transposition signal being different from the first transposition signal; and an output mixer in communication with the bandpass filter and the second signal generator and configured to receive the filter output and the second transposition signal, the output mixer configured to produce an RF output based on frequency-converting the filter output to a second frequency band based on mixing with the second transposition signal, the second frequency band being different from the first frequency band.

In another embodiment, the present disclosure provides a band select filter comprising: a first set of signal generators for generating a first set of transposition signals; a set of input mixers in communication with the first set of signal generators and configured to receive the first set of transposition signals and a radio frequency (RF) input at a first frequency within an first RF band, the set of input mixers configured to output a first set of frequency-converted RF inputs based on mixing the RF input with the first set of transposition signals; a set of bandpass filters in communication with the set of input mixers and configured to receive the first set of frequency-converted RF inputs, the set of bandpass filters producing a set of filter outputs based on applying filter characteristics to the set of frequency-converted RF inputs; a second set of signal generators for generating a second set of transposition signals, the second set of transpositions signal being different from the first set of transposition signals; and a set of output mixers in communication with the set of bandpass filters and the set of second signal generators and configured to receive the set of filter outputs and the second set of transposition signals, the set of output mixers configured to produce a set of RF outputs based on frequency-converting the filter outputs to a second frequency band based on mixing with the set of second transposition signals, the second frequency band being different from the first frequency band.

In an example embodiment, the band select filter further comprises one or more preselect filters configured to receive the RF input and to provide a filtered version of the RF input to the set of input mixers.

In an example embodiment, the band select filter further comprises a set of lowpass roofing filters configured to receive and process the set of RF outputs for transmission on a plurality of frequency channels.

In a further embodiment, the present disclosure provides a band select filter comprising: a first signal generator for generating a first transposition signal; an input mixer in communication with the first signal generator and configured to receive the first transposition signal and a radio frequency (RF) input at a first frequency within an first RF band, the input mixer configured to output a frequency-converted RF input based on mixing the RF input with the first transposition signal; a first bandpass filter in communication with the input mixer and configured to receive the frequency-converted RF input, the bandpass filter producing a first filter output based on applying a first filter characteristic based on a first passband to the frequency-converted RF input; a second signal generator for generating a second transposition signal, the second transposition signal being different from the first transposition signal; an intermediate mixer in communication with the second signal generator and configured to receive the second transposition signal and the first filter output, the input mixer configured to output a frequency-converted first filter output based on mixing the first filter output with the second transposition signal; a second bandpass filter in communication with the intermediate mixer and configured to receive the frequency-converted first filter output, the bandpass filter producing a second filter output based on applying a second filter characteristic based on a second passband to the frequency-converted first filter output, the second passband being different from and having a different center frequency compared to the first passband; a third signal generator for generating a third transposition signal, the third transposition signal being different from the first transposition signal and the second transposition signal; and an output mixer in communication with the second bandpass filter and the third signal generator and configured to receive the second filter output and the third transposition signal, the output mixer configured to produce an RF output based on frequency-converting the second filter output to a third frequency band based on mixing with the third transposition signal, the third frequency band being different from the first frequency band, the RF output having a third passband based on an overlap of the first passband of the first bandpass filter and the second passband of the second bandpass filter.

In another embodiment, the present disclosure provides a band select filter comprising: a first set of signal generators for generating a first set of transposition signals; a set of input mixers in communication with the first set of signal generators and configured to receive the first set of transposition signals and a radio frequency (RF) input at a first frequency within an first RF band, the set of input mixers configured to output a first set of frequency-converted RF inputs based on mixing the RF input with the first set of transposition signals; a set of bandpass filters in communication with the set of input mixers and configured to receive the first set of frequency-converted RF inputs, the set of bandpass filters producing a set of filter outputs based on applying filter characteristics to the set of frequency-converted RF inputs; a second set of signal generators for generating a second set of transposition signals, the second set of transpositions signal being different from the first set of transposition signals; and a set of output mixers in communication with the set of bandpass filters and the set of second signal generators and configured to receive the set of filter outputs and the second set of transposition signals, the set of output mixers configured to produce a set of RF outputs based on frequency-converting the filter outputs to a second frequency band based on mixing with the set of second transposition signals, the second frequency band being different from the first frequency band.

In a further embodiment, the present disclosure provides a method of implementing a band select filter comprising: generating a first transposition signal; receiving the first transposition signal and a radio frequency (RF) input at a first frequency within an first RF band, and outputting a frequency-converted RF input based on mixing the RF input with the first transposition signal; receiving the frequency-converted RF input and producing a filter output based on applying a filter characteristic to the frequency-converted RF input; generating a second transposition signal, the second transposition signal being different from the first transposition signal; and receiving the filter output and the second transposition signal and producing an RF output based on frequency-converting the filter output to a second frequency band based on mixing with the second transposition signal, the second frequency band being different from the first frequency band.

In another embodiment, the present disclosure provides a system for implementing a band select filter comprising: a non-transient computer-readable storage medium having executable instructions embodied thereon; and one or more hardware processors configured to execute the instructions to perform a method as described and illustrated herein.

In another embodiment, the present disclosure provides a non-transient computer-readable storage medium having instructions embodied thereon, the instructions being executable by one or more processors to perform a method of implementing a band select filter as described and illustrated herein.

A filter, apparatus, system and method are provided for implementing a band select filter, for example a frequency agile band select filter. In an implementation, the filter includes two separate signal generators configured to provide different local oscillator signals to an input mixer and to an output mixer, resulting in the filter output frequency being different from the filter input frequency. This is in contrast to known approaches which use the same signal generator to drive both input and output mixers. The filter may include two bandpass filters, three mixers, and three signal generators, each signal generator uniquely associated with one of the mixers, and configured to provide bandwidth control. A system of filters may include a set of bandpass filters, a plurality of sets of mixers, and a plurality of sets of signal generators, each set of signal generators being associated with a different set of mixers.

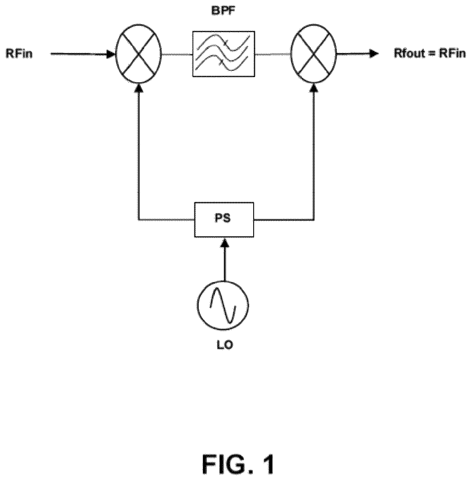

FIG. 1 is a block diagram of a known filter transposition architecture including two mixers and one bandpass filter. In the system of FIG. 1, the same LO frequency source is used to power both an input mixer receiving a signal RFin, and an output mixer configured to generate a signal RFout, which is equal in frequency to RFin, based on an output of the bandpass filter.

In many communication systems there is a requirement to select closely spaced channels in the frequency domain whilst rejected the adjacent frequency spectrum. Specifically, in satellite communication transponders, a received uplink signal must be converted to a specific downlink frequency to establish a connection. Often there are multiple channels that required to be independently selected for operation.

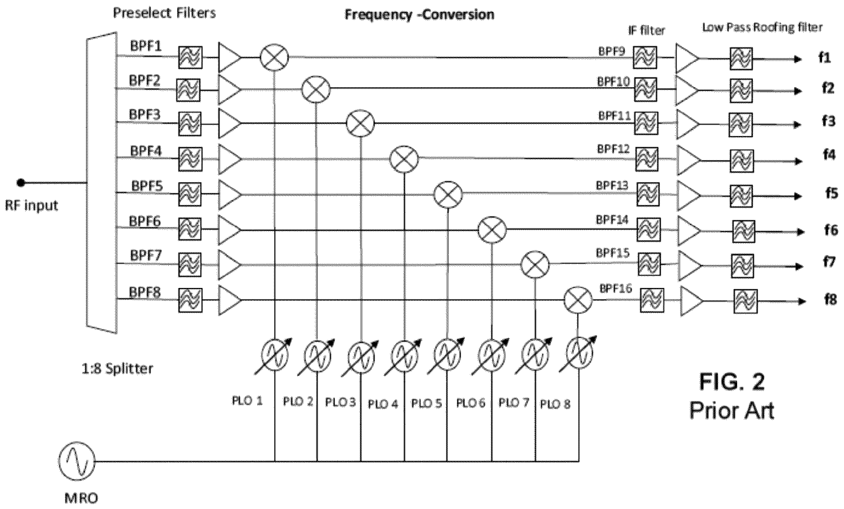

FIG. 2 is a block diagram of a known filter transposition architecture including eight mixers and sixteen bandpass filters. The system of FIG. 2 is similar in approach to the system of FIG. 1. Conventionally, as shown in FIG. 2, a series of narrow channel select filters are used, one dedicated to each frequency band. Each frequency band may have a plurality of sub-channels, for example 5-6 sub-channels. In order to achieve the necessary adjacent channel rejection, surface acoustic wave filters (or waveguide filters for microwave frequencies such as Ku band and above) are often used.

In FIG. 2, a broadband RF signal is applied to a bank of pre-select filters, BPF 1 to BPF 8. The pre-select filters isolate specific bands containing several channels to be selected. The selected frequency band is applied to a frequency converter which operates either to up or down convert the selected frequency band in accordance with the system frequency plan. The frequency conversion is realized using a series of phase locked oscillators, PLO 1 to 8 which are phase locked to the master reference oscillator MRO. The bandpass filters BPF 9 to BPF 16 have a bandwidth equal to the channel bandwidth. In the known implementation of FIG. 2, the system includes 16 completely different filters. This can be difficult and expensive from a design and cost perspective, on top of the consideration that there is likely to be a thermally induced drift in the center frequency for each filter.

Based on the setting of the PLO frequency different channels can be selected. The preselect bandpass filter and channel select bandpass filters have a set of center frequencies that are unique to the converter application preventing its use in applications not adhering to the same frequency plan.

The conventional approach of FIG. 2 requires a dedicated filter configuration for each band of interest. A consequence of this is that if, for example, there are 8 frequency channels, then eight unique filter frequencies will be required. In some cases, not all channels are in use, which means the system suffers increased size and weight in order to accommodate the non-operational filter banks and converters.

The conventional approach of FIG. 2 is reliant on a specific series of bandpass filters to achieve channel selection. The filters must meet stringent passband and rejection requirements for the system to operate. As a consequence of each bandpass filter being unique, the system has a single point of failure. In order to introduce redundancy into the system, it is necessary to have duplicate banks of filters leading to increase in the size, weight and power consumption of the resultant unit.

Use of application-specific bandpass filters limits the operation of the resultant channel select filter to a specific application defined by the filters, necessitating costly re-design of the equipment in the case that operational requirements change. The pass band characteristic of SAW filter technology is subject to thermal drift consequently the filter band must include a frequency guard band to account for changes in the filter center frequency.

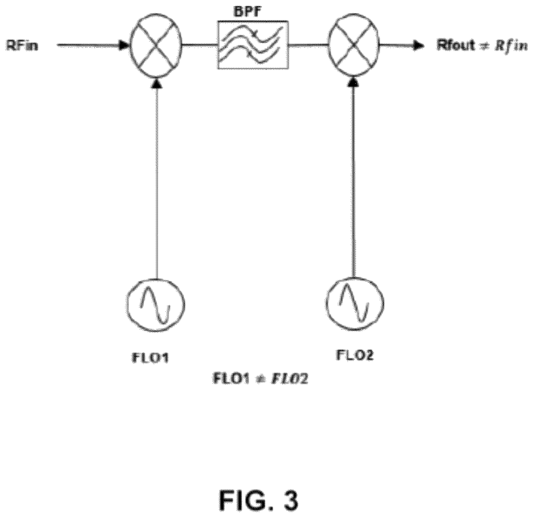

FIG. 3 is a block diagram of a filter transposition architecture according to an embodiment of the present disclosure, including two mixers and one bandpass filter, and two different frequency sources. In embodiments described herein, the systems, filters and methods are configured to perform frequency conversion. In an example embodiment, the frequency conversion comprises down-conversion. In another example embodiment, the frequency conversion comprises up-conversion.

A filter transposition architecture according to one or more embodiments may be described as a Frequency Agile Band Select Filter (FABSF). The FABSF may comprise multiple frequency conversion stages, or a plurality of frequency conversion stages. In the example embodiment as shown in FIG. 3, the system comprises two frequency conversion stages, which enable the input frequency to be translated to a different RF output frequency.

In the known approach of FIG. 1, the input frequency is translated to the same RF output frequency and as a consequence the local oscillator supplied to the different mixers providing the translation can be the same. In the case of the FABSF of FIG. 3, two separate local oscillators are provided, and are operated at different frequencies. This enables the output frequency to be different from the input frequency, while maintaining the same filter between the two mixers. In other embodiments, a FABSF of an embodiment of the disclosure comprises a plurality of local oscillators, where each of the plurality of local oscillators may be operated at different frequencies. In an example embodiment, the plurality of local oscillators are operated at different frequencies. While the apparatus of FIG. 3 illustrates the oscillators as PLO (phase-locked oscillator), in other embodiments to oscillators comprise any type of oscillator. The oscillators may be phase locked to the MRO to maintain the frequency stability requirement of the system.

The FABSF embodiment of FIG. 3 is advantageous over a conventional band select filter in that the FABSF can be an identical unit with and identical filter for each channel. The different frequency channels result from the setting of the FABSF local oscillator frequencies.

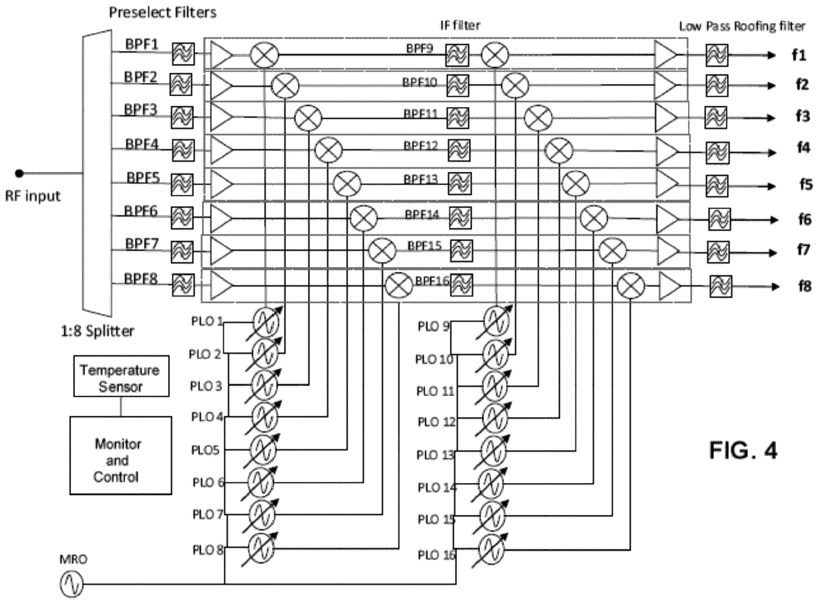

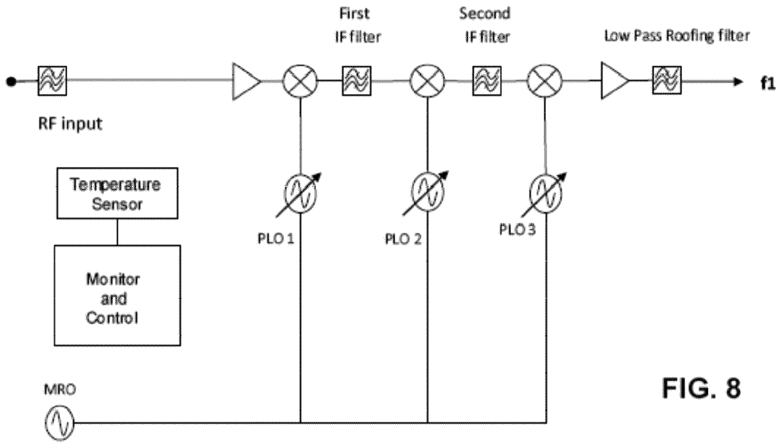

FIG. 4 is a block diagram of a multi-channel frequency agile band select filter according to an embodiment of the present disclosure. The embodiment of FIG. 8 illustrates an implementation using 8 channels. Other embodiments of the present disclosure may have any number of a plurality of channels, for example three or four channels, or more. While the conventional band select filter as shown in FIG. 2 requires 8 filters to separate 8 channels, in contrast the FABSF as shown in FIG. 4 may be configured with one filter, and the mixer LO frequencies may be set to enable translation of the input frequency to any of the required 8 output channel frequencies, while using the same bandpass filter. This results in increased system flexibility compared to the known approach.

In some cases, a selection of 4 channels of the available 8 may be in use at any one time. If a conventional band select filter such as shown in FIG. 3 is used, 8 filters will be required, for which at any instance in time 4 will be redundant, occupying size weight and power. In the case of the FABSF embodiment of FIG. 4, in an implementation 4 filters can be used and electronically reconfigured for the additional bands as required. This minimizes the size weight and power requirement of the system.

Consider an implementation in which 8 FABSF filters are used to address a system previously catered to by a conventional band select filter. In the embodiment of FIG. 4, as all the FABSF filters are identical, the filters can be reconfigured to provide redundant operation in the case that a filter fails. In the case of the conventional band select filter such as shown in FIG. 3, the use of 8 different band select filters prevents any of the unused filters being used in place of a failed channel; as a result, each filter in the conventional approach of FIG. 3 represents a single point of failure.

Frequency spectrum is often at a premium. As such, in an example embodiment of the system of FIG. 4, channels may be placed as close together as is feasible based on the channel select filters available. In an example embodiment, the filters may have steep transition bands in order to provide the required adjacent channel rejection with the minimum spectral occupancy. The filters will be subject to thermally induced frequency drift, which will result in movement of the pass bands, which typically must be accounted for through guard bands. For example, if the system has a thermal range of 100 degrees and over that there is a 8 MHz shift in one of these filters, that can be problematic, which is a reason for providing a guard band; if they're all shifting in different directions, the situation is worse and more complicated to deal with. In the case of the FABSF embodiment of FIG. 4, the local oscillators associated with the translation mixers may be adjusted to compensate for the thermally induced frequency drift of the inter-stage filter; this reduces the guard band requirement, and consequently reduces the spectral occupancy of the overall system.

In the embodiment of FIG. 4, a broadband RF signal is applied to a bank of pre-select filters, BPF 1 to BPF 8. The preselect filters of the embodiment of FIG. 4 may all be the same type, and may select the entire band of interest. In an example embodiment, the pre-select filters are narrowband filters. In an example implementation in which the band of interest comprises separate RF bands, the system may comprise a dedicated pre-select filter per input band, as illustrated in FIG. 4.

As shown in FIG. 4, the band limited output from the preselect filter is applied to the first mixer which is used to frequency convert the selected input signal to the IF pass band of the channel select filters BPF 9 to BPF 16. In an example embodiment, these filters may all be identical, as it is the frequency setting of the input mixer local oscillators, PLO1 to PLO8 that determine the input RF frequency that passes through the IF filter. PLO 9 to PLO16 determine the output frequency of the selected channel. In an implementation, bandpass filters BPF 9 to BPF 16 have a bandwidth equal to the channel bandwidth. In an example embodiment, a channel select filter comprises a 200 MHz bandwidth filter, and a preselect filter comprises 1 GHz bandwidth filter; the system may effectively set a series of channel filters within that 1 GHz.

In an example implementation with one contiguous block of RF input, the system may comprise BPF1 to BPF8 which are all the same. In another example implementation with two blocks of RF input, the system may comprise a pre-filter function or set of pre-filters for the first block, and a pre-filter function or set of pre-filters for the second block. In an example implementation, the system down-converts to the channel select. In another example implementation, the system up-converts to the channel select.

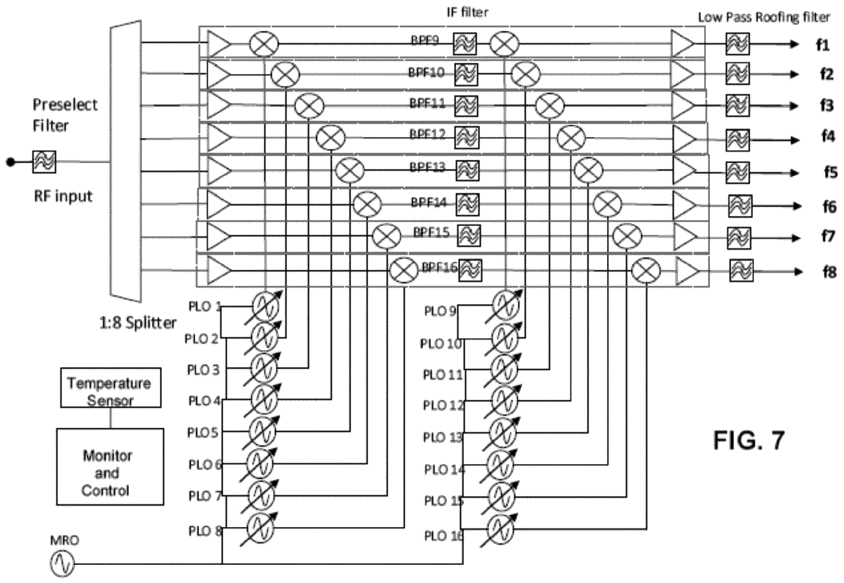

In the embodiment of FIG. 4, as well as the embodiment of FIG. 7 to be described later, BPF 9 to BPF 16 may be identical, which reduces the design complexity as only a single filter type is required to be manufactured. The embodiment of FIG. 4 may also accommodate a range of bandpass filters and bandpass filter types, as a result of the adjustability of the phase locked oscillator frequencies applied to the two mixers. This is advantageous as it removes the requirement for a specific filter type of known approaches, making the design more robust with respect to component obsolescence.

In the embodiment of FIG. 4, based on the setting of the local oscillator signal applied to the second mixer, the selected channel is converted to the required output frequency, completing the channel selection and conversion process. A monitor and control module or subassembly is shown in FIG. 4 and is configured to monitor the PLO lock signals and unit temperature. Based on the system temperature, PLO 9 to 16 frequencies may be adjusted either through look up tables or by using one channel as a calibration channel to correct from the channel select filter center frequency drift with temperature.

As shown in the embodiment of FIG. 4, the system may comprise a plurality of low pass roofing filters. The roofing filters are configured to address the harmonic on the output of each channel. Because the system and its components have a tolerance and a thermal dependence, the center frequency will move. As shown in FIG. 4, the system may comprise a temperature sensor, to sense the temperature and to provide a control signal to adjust the LOs to account in the shift of the center frequency. Such functionality is not possible with known approaches such as shown in FIG. 2 in which the same LO frequency is provided to an input mixer and to an output mixer.

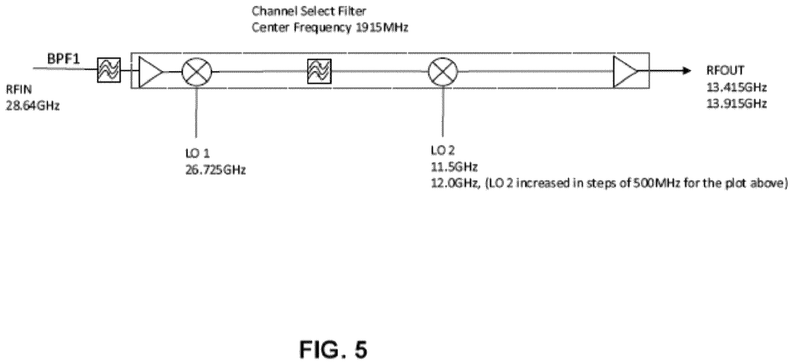

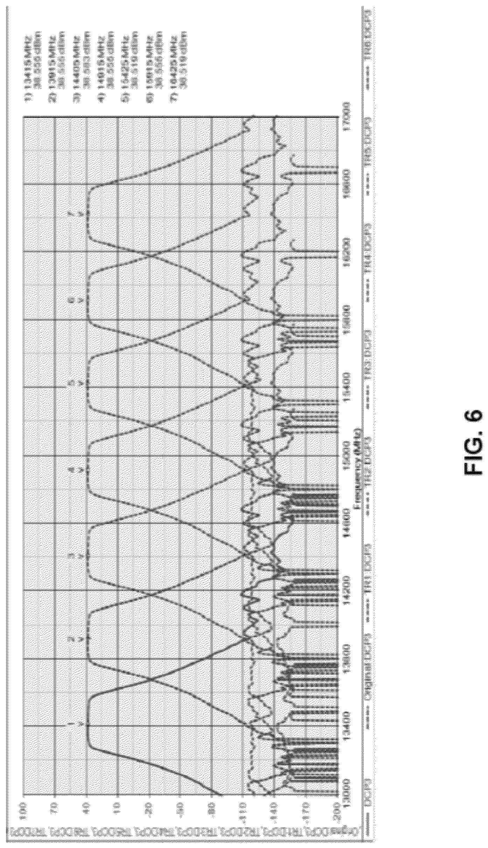

FIG. 5 is a block diagram of a single channel of the frequency agile band select filter of FIG. 4 according to an embodiment of the present disclosure. FIG. 6 is a plot illustrating outputs of the single channel shown in FIG. 5 of the frequency agile band select filter according to an embodiment of the present disclosure. The single channel "filter stick" shown in FIG. 5 comprises two mixers, a bandpass filter, and two local oscillators. The system of FIG. 5 is configured for frequency conversion, where the frequency conversion may be either up-conversion or down-conversion. For example, a low RF frequency may provided at the input, and the output ends up at a higher output frequency. The system as shown in FIG. 5 may be configured to perform either up-conversion or down-conversion, without having to modify the filters.

In an example embodiment, the input frequency RFin may have a frequency in the range of about 20 GHz to about 30 GHz, and may for example be 28.64 GHz as shown in FIG. 5. The output frequency RFout may be in the range of about 18 GHz to 19 GHz, or about 10 GHz, and may for example be 13.415 GHz as shown in FIG. 5. In such an example implementation, the channel select filter may have a center frequency of 1915 MHz, and L01 may have a frequency of 26.725 GHz. In this example, LO2 may have a frequency of 11.5 GHz, and may be increased by a frequency stepping value, for example in steps of 500 MHz with the next increase being 12.0 GHz. This results in the RF output frequency increasing from 13.415GHz at an LO2 setting of 11.5GHz, to 13.915GHz at an LO2 setting of 12.0GHz. The RF output frequency is the sum of the filter center frequency of, 1915MHz and the setting of LO2.

FIG. 7 is a block diagram of a multi-channel frequency agile band select filter with common input preselect filter according to an embodiment of the present disclosure. In an implementation in which the RF input band is contiguous in frequency, the pre-select filters BPF 1 to BPF 8 from FIG. 4 may be replaced with a single preselect filter common to all the RF input paths, as illustrated in the embodiment of FIG. 7.

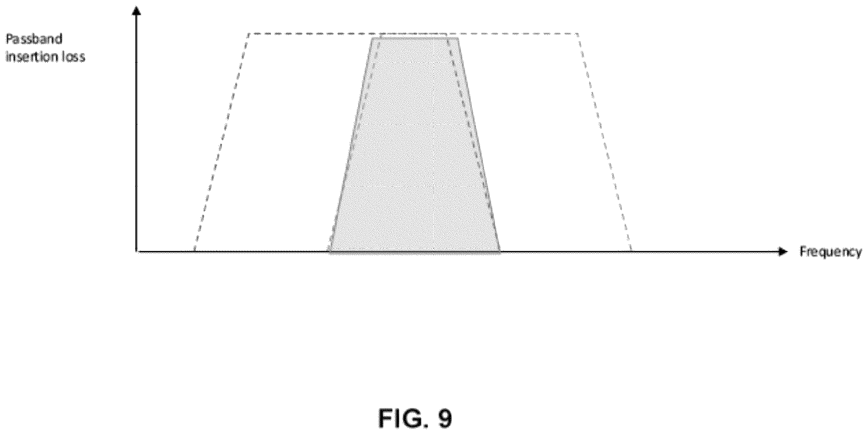

FIG. 8 is a block diagram of a frequency agile band select filter with channel select filter bandwidth control according to an embodiment of the present disclosure. The system of FIG. 8 is configured for frequency conversion, where the frequency conversion may be either up-conversion or down-conversion. For example, an RF input may be down-converted to a first intermediate frequency, then up or down-converted to a second intermediate frequency, which is different from the first intermediate frequency. The two filters have different passband center frequencies offset from each other. The selection of the PLO2 frequency determines what part of the signal leaving the first bandpass filter will pass through the second bandpass filter, resulting in an effective overlap of the filter passbands, as shown and described later in relation to FIG. 9.

For example, consider an example implementation in which the first bandpass filter is centered at 1915 MHz and has a 200 MHz passband. The output from the first bandpass filter is down-converted, and provided as an input to the second bandpass filter, which is centered at 1415 MHz and has a bandwidth of 200 MHz. If the PLO 2 is set to 400 MHz, then the passband of the 1915 MHz filter will be completely down-converted to the passband of the 1415 MHz filter. If PLO 2 is set to 450 MHz then the passband of the 1915 MHz filter will be offset by 50 MHz relative to the 1415 MHz filter, leading to a reduction of the effective passband of the overall filter system by 50 MHz, and a filter overlap of 150 MHz will result. The change in effective bandwidth can be seen in FIG. 9, based on an overlap of the two passband characteristics.

The embodiment of FIG. 8 provides resilience with respect to the availability of a filter. For example, if a 150 MHz bandwidth filter is required, but only a 200 MHz bandwidth filter is available, it would typically be necessary to adjust an existing design or create a customized design based on the available components, which varied from the components contemplated in an original design. The embodiment of FIG. 8 provides resilience with respect to not just temporary availability of a filter, but even in the case where a part that is included in a design is discontinued or becomes obsolete, and needs to be replaced by a different component. The embodiment of FIG. 8 also provides resilience with respect to potential changes in design, for example if it becomes desirable for the system to have a 140 MHz bandwidth filter, rather than a 150 MHz bandwidth filter.

In the embodiment of FIG. 8, the bandwidth is adjustable through the addition of an inter-stage mixer and an additional PLO. The inter-stage mixer and the additional PLO allow two IF filters to be intentionally overlapped, enabling control over the pass band characteristic. Such a configuration is shown for one conversion stage in FIG. 8. In some other known approaches, four mixers are provided, since the system needs to get back to the same frequency that it started from. In the embodiment of FIG. 8, the system has three mixers because it's going back up to a different frequency to the one the system started from. The example embodiment of FIG. 8 also comprises a roofing filter at the output, similar to previously described embodiments. The roofing filter assists with mitigating the certain amount of LO leakage in the channel, as well as harmonic rejection. Other embodiments may omit the roofing filter(s).

FIG. 9 is a plot illustrating overlapping filter characteristics of the frequency agile band select filter with channel select filter bandwidth control according to the embodiment of FIG. 8. The plot of FIG. 9 illustrates passband insertion loss versus frequency. The dashed line filter characteristics on the left represent a first passband associated with the first IF filter in FIG. 8. The dashed line filter characteristics on the right represent a second passband associated with the second IF filter in FIG. 8. The shaded portion represents overlapped filter characteristics from the first and second IF filters which provide control over the overall passband bandwidth through, or by way of, adjustment of PLO2.

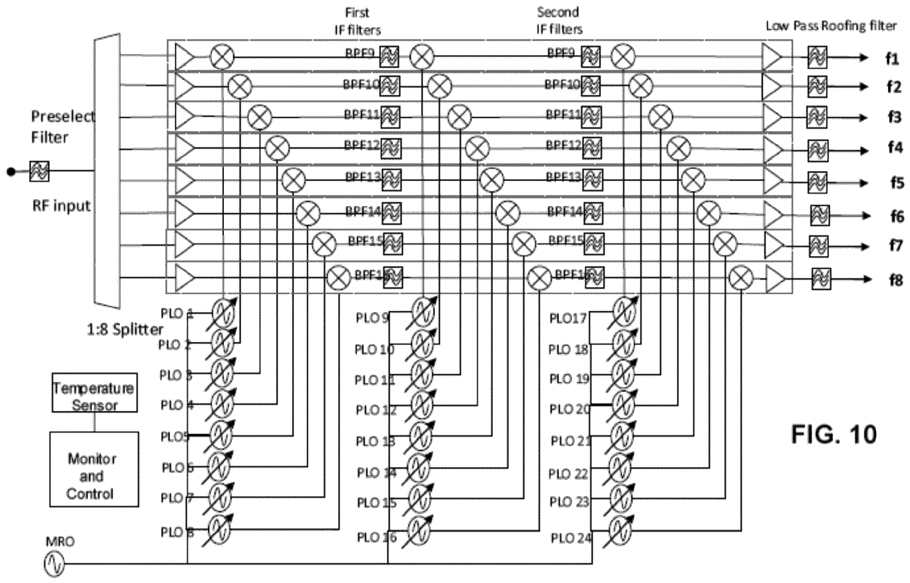

FIG. 10 is a block diagram of a multi-channel frequency agile band select filter with IF filter bandwidth control according to an embodiment of the present disclosure. The embodiment shown in FIG. 10 is a multi-channel implementation of the bandwidth adjustable channel select filter of FIG. 8.

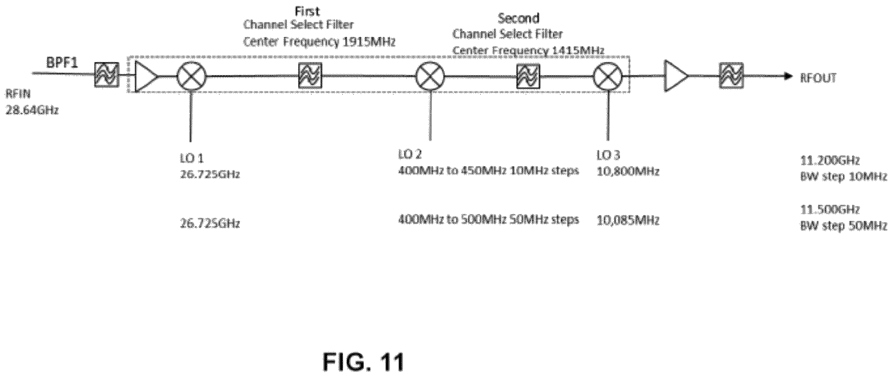

FIG. 11 is a block diagram of a single channel of the frequency agile band select filter of FIG. 8 or FIG. 10 according to an embodiment of the present disclosure. In an example embodiment, the frequency of LO1 is fixed, and the LO2 and LO3 frequencies are stepped up by a frequency stepping value, for example in increments of 10 MHz or 50 MHz. Other pass band adjustment increments are possible, with the minimum passband being set by the transition band of the filters. Dynamic control of the passband may be required if the same filter stick is used to address different spectral regions where channel bandwidth is different. The different spectral regions may be accessed through adjustment of LO1 and the band adjustment would then be through adjustment of LO2 to match the channel spacing. LO3 then sets the output frequency at which the selected channel is issued from the filter. The input frequency LO1 is a fixed frequency in this case.

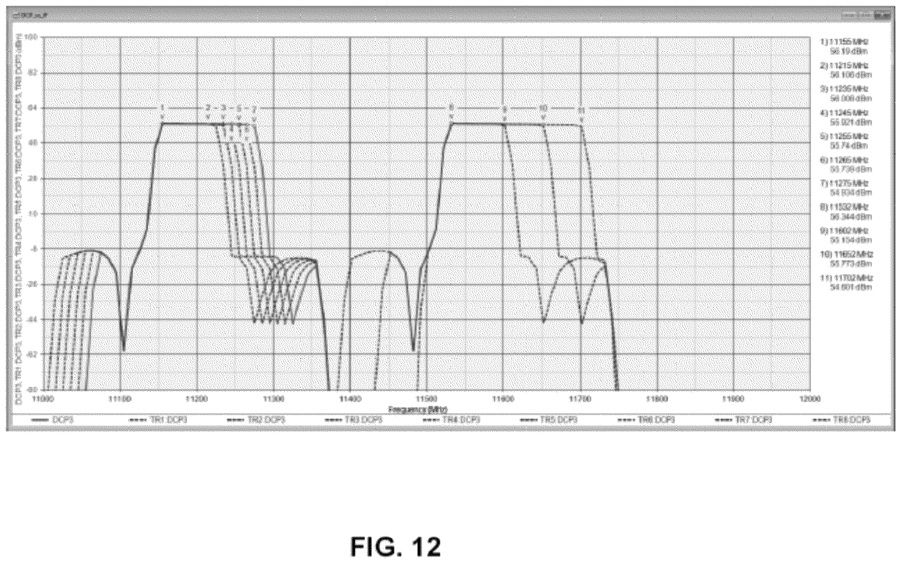

FIG. 12 is a plot illustrating outputs of the single channel shown in FIG. 11 of the frequency agile band select filter including filter bandwidth control according to an embodiment of the present disclosure.

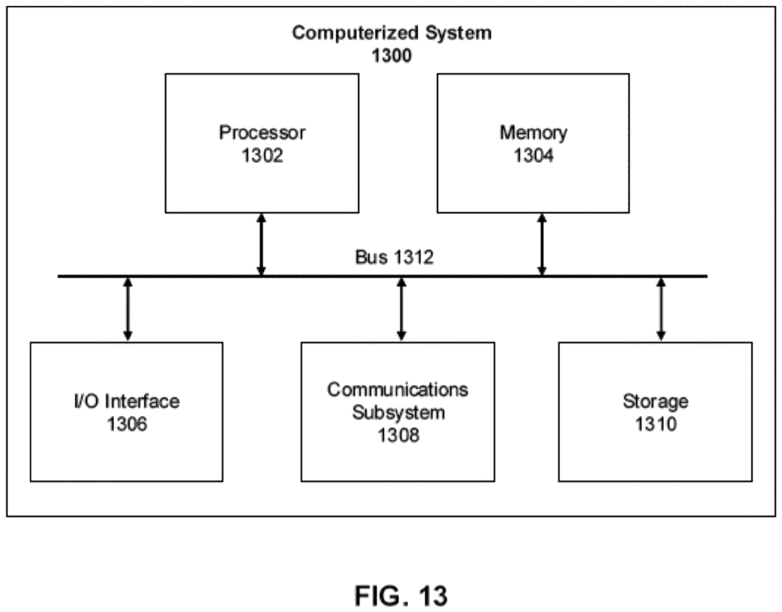

FIG. 13 is a block diagram of an example computerized device or system 1300 that may be used in implementing one or more aspects or components of an embodiment of a frequency agile band select filter in accordance with the present disclosure, for example implementing one or more elements, or sub-components, as described in relation to the frequency agile band select filters, possibly with bandwidth control, providing functionality similar to the filters in FIG. 3, FIG. 4, FIG. 5, FIG. 7, FIG. 8, FIG. 10 and/or FIG. 11, and/or for implementing one or more operations of methods based on the functions of such filter(s).

Computerized system 1300 may include one or more of a processor 1302, memory 1304, a mass storage device 1310, an input/output (I/O) interface 1306, and a communications subsystem 1308. Further, system 1300 may comprise multiples, for example multiple processors 1302, and/or multiple memories 1304, etc. Processor 1302 may comprise one or more of a digital processor, an analog processor, a digital circuit designed to process information, an analog circuit designed to process information, a state machine, and/or other mechanisms for electronically processing information. These processing units may be physically located within the same device, or the processor 1302 may represent processing functionality of a plurality of devices operating in coordination. The processor 1302 may be configured to execute modules by software; hardware; firmware; some combination of software, hardware, and/or firmware; and/or other mechanisms for configuring processing capabilities on the processor 1302, or to otherwise perform the functionality attributed to the module and may include one or more physical processors during execution of processor readable instructions, the processor readable instructions, circuitry, hardware, storage media, or any other components.

One or more of the components or subsystems of computerized system 1300 may be interconnected by way of one or more buses 1312 or in any other suitable manner.

The bus 1312 may be one or more of any type of several bus architectures including a memory bus, storage bus, memory controller bus, peripheral bus, or the like. The CPU 1302 may comprise any type of electronic data processor. The memory 1304 may comprise any type of system memory such as dynamic random access memory (DRAM), static random access memory (SRAM), synchronous DRAM (SDRAM), read-only memory (ROM), a combination thereof, or the like. In an embodiment, the memory may include ROM for use at boot-up, and DRAM for program and data storage for use while executing programs.

The mass storage device 1310 may comprise any type of storage device configured to store data, programs, and other information and to make the data, programs, and other information accessible via the bus 1312. The mass storage device 1310 may comprise one or more of a solid state drive, hard disk drive, a magnetic disk drive, an optical disk drive, or the like. In some embodiments, data, programs, or other information may be stored remotely, for example in the cloud. Computerized system 1300 may send or receive information to the remote storage in any suitable way, including via communications subsystem 1308 over a network or other data communication medium.

The I/O interface 1306 may provide interfaces for enabling wired and/or wireless communications between computerized system 1300 and one or more other devices or systems. For instance, I/O interface 1306 may be used to communicatively couple with sensors, such as cameras or video cameras. Furthermore, additional or fewer interfaces may be utilized. For example, one or more serial interfaces such as Universal Serial Bus (USB) (not shown) may be provided.

Computerized system 1300 may be used to configure, operate, control, monitor, sense, and/or adjust devices, systems, and/or methods according to the present disclosure.

A communications subsystem 1308 may be provided for one or both of transmitting and receiving signals over any form or medium of digital data communication, including a communication network. Examples of communication networks include a local area network (LAN), a wide area network (WAN), an inter-network such as the Internet, and peer-to-peer networks such as ad hoc peer-to-peer networks. Communications subsystem 1308 may include any component or collection of components for enabling communications over one or more wired and wireless interfaces. These interfaces may include but are not limited to USB, Ethernet (e.g. IEEE 802.3), high-definition multimedia interface (HDMI), Firewire^{™} (e.g. IEEE 1394), Thunderbolt^{™}, WiFi^{™} (e.g. IEEE 802.11), WiMAX (e.g. IEEE 802.16), Bluetooth^{™}, or Near-field communications (NFC), as well as GPRS, UMTS, LTE, LTE-A, and dedicated short range communication (DSRC). Communication subsystem 1308 may include one or more ports or other components (not shown) for one or more wired connections. Additionally or alternatively, communication subsystem 1308 may include one or more transmitters, receivers, and/or antenna elements (none of which are shown).

Computerized system 1300 of FIG. 13 is merely an example and is not meant to be limiting. Various embodiments may utilize some or all of the components shown or described. Some embodiments may use other components not shown or described but known to persons skilled in the art.

In the preceding description, for purposes of explanation, numerous details are set forth in order to provide a thorough understanding of the embodiments. However, it will be apparent to one skilled in the art that these specific details are not required. In other instances, well-known electrical structures and circuits are shown in block diagram form in order not to obscure the understanding. For example, specific details are not provided as to whether the embodiments described herein are implemented as a software routine, hardware circuit, firmware, or a combination thereof.

Embodiments of the disclosure can be represented as a computer program product stored in a machine-readable medium (also referred to as a computer-readable medium, a processor-readable medium, or a computer usable medium having a computer-readable program code embodied therein). The machine-readable medium can be any suitable tangible, non-transitory medium, including magnetic, optical, or electrical storage medium including a diskette, compact disk read only memory (CD-ROM), memory device (volatile or non-volatile), or similar storage mechanism. The machine-readable medium can contain various sets of instructions, code sequences, configuration information, or other data, which, when executed, cause a processor to perform steps in a method according to an embodiment of the disclosure. Those of ordinary skill in the art will appreciate that other instructions and operations necessary to implement the described implementations can also be stored on the machine-readable medium. The instructions stored on the machine-readable medium can be executed by a processor or other suitable processing device, and can interface with circuitry to perform the described tasks.

The above-described embodiments are intended to be examples only. Alterations, modifications and variations can be effected to the particular embodiments by those of skill in the art without departing from the scope, which is defined solely by the claims appended hereto.

## Claims

1. A band select filter comprising:
a first signal generator for generating a first transposition signal;
an input mixer in communication with the first signal generator and configured to receive the first transposition signal and a radio frequency (RF) input at a first frequency within an first RF band, the input mixer configured to output a frequency-converted RF input based on mixing the RF input with the first transposition signal;
a bandpass filter in communication with the input mixer and configured to receive the frequency-converted RF input, the bandpass filter producing a filter output based on applying a filter characteristic to the frequency-converted RF input;
a second signal generator for generating a second transposition signal, the second transposition signal being different from the first transposition signal; and
an output mixer in communication with the bandpass filter and the second signal generator and configured to receive the filter output and the second transposition signal, the output mixer configured to produce an RF output based on frequency-converting the filter output to a second frequency band based on mixing with the second transposition signal, the second frequency band being different from the first frequency band.

2. A band select filter comprising:
a first set of signal generators for generating a first set of transposition signals;
a set of input mixers in communication with the first set of signal generators and configured to receive the first set of transposition signals and a radio frequency (RF) input at a first frequency within an first RF band, the set of input mixers configured to output a first set of frequency-converted RF inputs based on mixing the RF input with the first set of transposition signals;
a set of bandpass filters in communication with the set of input mixers and configured to receive the first set of frequency-converted RF inputs, the set of bandpass filters producing a set of filter outputs based on applying filter characteristics to the set of frequency-converted RF inputs;
a second set of signal generators for generating a second set of transposition signals, the second set of transpositions signal being different from the first set of transposition signals; and
a set of output mixers in communication with the set of bandpass filters and the set of second signal generators and configured to receive the set of filter outputs and the second set of transposition signals, the set of output mixers configured to produce a set of RF outputs based on frequency-converting the filter outputs to a second frequency band based on mixing with the set of second transposition signals, the second frequency band being different from the first frequency band.

3. The band select filter of claim 2 further comprising:
one or more preselect filters configured to receive the RF input and to provide a filtered version of the RF input to the set of input mixers.

4. The band select filter of claim 2 further comprising:
a set of lowpass roofing filters configured to receive and process the set of RF outputs for transmission on a plurality of frequency channels.

5. A band select filter comprising:
a first signal generator for generating a first transposition signal;
an input mixer in communication with the first signal generator and configured to receive the first transposition signal and a radio frequency (RF) input at a first frequency within an first RF band, the input mixer configured to output a frequency-converted RF input based on mixing the RF input with the first transposition signal;
a first bandpass filter in communication with the input mixer and configured to receive the frequency-converted RF input, the bandpass filter producing a first filter output based on applying a first filter characteristic based on a first passband to the frequency-converted RF input;
a second signal generator for generating a second transposition signal, the second transposition signal being different from the first transposition signal;
an intermediate mixer in communication with the second signal generator and configured to receive the second transposition signal and the first filter output, the input mixer configured to output a frequency-converted first filter output based on mixing the first filter output with the second transposition signal;
a second bandpass filter in communication with the intermediate mixer and configured to receive the frequency-converted first filter output, the bandpass filter producing a second filter output based on applying a second filter characteristic based on a second passband to the frequency-converted first filter output, the second passband being different from and having a different center frequency compared to the first passband;
a third signal generator for generating a third transposition signal, the third transposition signal being different from the first transposition signal and the second transposition signal; and
an output mixer in communication with the second bandpass filter and the third signal generator and configured to receive the second filter output and the third transposition signal, the output mixer configured to produce an RF output based on frequency-converting the second filter output to a third frequency band based on mixing with the third transposition signal, the third frequency band being different from the first frequency band, the RF output having a third passband based on an overlap of the first passband of the first bandpass filter and the second passband of the second bandpass filter.

6. A band select filter comprising:
a first set of signal generators for generating a first set of transposition signals;
a set of input mixers in communication with the first set of signal generators and configured to receive the first set of transposition signals and a radio frequency (RF) input at a first frequency within an first RF band, the set of input mixers configured to output a first set of frequency-converted RF inputs based on mixing the RF input with the first set of transposition signals;
a set of bandpass filters in communication with the set of input mixers and configured to receive the first set of frequency-converted RF inputs, the set of bandpass filters producing a set of filter outputs based on applying filter characteristics to the set of frequency-converted RF inputs;
a second set of signal generators for generating a second set of transposition signals, the second set of transpositions signal being different from the first set of transposition signals; and
a set of output mixers in communication with the set of bandpass filters and the set of second signal generators and configured to receive the set of filter outputs and the second set of transposition signals, the set of output mixers configured to produce a set of RF outputs based on frequency-converting the filter outputs to a second frequency band based on mixing with the set of second transposition signals, the second frequency band being different from the first frequency band.

7. A method of implementing a band select filter comprising:
generating a first transposition signal;
receiving the first transposition signal and a radio frequency (RF) input at a first frequency within an first RF band, and outputting a frequency-converted RF input based on mixing the RF input with the first transposition signal;
receiving the frequency-converted RF input and producing a filter output based on applying a filter characteristic to the frequency-converted RF input;
generating a second transposition signal, the second transposition signal being different from the first transposition signal; and
receiving the filter output and the second transposition signal and producing an RF output based on frequency-converting the filter output to a second frequency band based on mixing with the second transposition signal, the second frequency band being different from the first frequency band.

8. A system for implementing a band select filter comprising:
a non-transient computer-readable storage medium having executable instructions embodied thereon; and
one or more hardware processors configured to execute the instructions to perform the method of claim 7.

9. A non-transient computer-readable storage medium having instructions embodied thereon, the instructions being executable by one or more processors to perform the method of claim 7.
